(19) Europäisches Patentamt
European Patent Office
Office européen des brevets

(11) **EP 1 522 893 B1**

(12) **EUROPEAN PATENT SPECIFICATION**

(45) Date of publication and mention
of the grant of the patent:
**29.04.2009 Bulletin 2009/18**

(51) Int Cl.:
***G03F 7/20*** (2006.01)

(21) Application number: **04023064.1**

(22) Date of filing: **28.09.2004**

(54) **Illumination optical system and exposure apparatus having the same**

Optisches Beleuchtungssystem und damit versehener Belichtungsapparat

Système d'illumination optique et appareil d'exposition le comprenant

(84) Designated Contracting States:
**DE NL**

(30) Priority: **06.10.2003 JP 2003347167**

(43) Date of publication of application:
**13.04.2005 Bulletin 2005/15**

(73) Proprietor: **CANON KABUSHIKI KAISHA**
**Tokyo (JP)**

(72) Inventor: **Orino, Kanjo**
**Tokyo (JP)**

(74) Representative: **TBK-Patent**
**Bavariaring 4-6**
**80336 München (DE)**

(56) References cited:
**EP-A- 1 308 780        US-A- 5 955 243**
**US-A1- 2001 033 433    US-A1- 2001 043 408**

**Description**

The present invention relates generally to an illumination optical system and an exposure apparatus using the same, and more particularly to an illumination optical system that includes a condenser optical system for irradiating the light from a light source onto an object surface, and an exposure apparatus using the same.

The conventional semiconductor device manufacturing process for forming ultra fine patterns, such as LSIs and very LSIs, has employed a reduction projection exposure apparatus that projects a reduced size of a circuit pattern on a reticle onto an object to be exposed, such as a photosensitive-agent applied silicon wafer. As the improved packaging density of the semiconductor devices requires finer circuit patterns, the exposure apparatus is required to promote the finer processing.

One measure to promote the fine processing generally is to increase a numerical aperture ("NA"), such as a NA of 0.8 or higher, but the high NA reduces a depth of focus. Accordingly, an object-side telecentric projection optical system that maintains as parallel as possible a principal ray of the light that images on the object to be exposed, is used to maintain a wider practical depth of focus for exposures of circuit patterns.

Manufacturing errors that occur in manufacturing a projection exposure apparatus, such as processing size errors of optical elements, coating errors of antireflection coatings of the optical elements and dielectric multilayer coatings of highly reflective mirrors, and assembly errors of optical systems, deteriorate the parallelism of the principal ray of the light that finally images on the object or offsets the telecentricity at the wafer side. This would cause asymmetrical incident angles of the imaging rays at the wafer side, a distorted effective light source, and uneven critical dimensions that have been exposed.

Various solution methods have been conventionally proposed. See, for example, documents JP-A-2001-155993 and JP-A-2002-184676. The former reference proposes to arrange a rod-type optical integrator in front of a condenser optical system. The latter reference includes two lens units movable in the optical-axis direction in a condenser optical system that is arranged after a fly-eye lens. This reference corrects the telecentricity using the front unit, and the focus offset by movements of the front unit using the back unit.

However, the former reference causes wide focus movements of the condenser optical system on the surface to be illuminated, and significant spot-diameter fluctuations associated with the movements of the condenser optical system. This lowers the illumination efficiency for the illuminated surface, and deteriorates the throughput in manufacturing semiconductor devices using this projection exposure apparatus. The latter reference corrects the focus movements as one problem in the former reference, but requires two movable units, disadvantageously causing a complex, large and expensive mechanism for a barrel's movable part.

Document US 2001/0033433 A1 discloses an illumination optical system for illuminating an object surface using light from a light source, wherein the illumination optical system includes a condenser optical system for directing the light from the light source to the object surface. The condenser optical system includes, in order from an incident side, a first and a second optical system. The first optical system includes at least two lens elements which are movable along an optical axis independently of each other, wherein the lens element on the incident side has a positive refractive power. This known condenser optical system is designed such that the principle rays of light directed onto the object surface to be illuminated can be maintained as parallel to the optical axis as possible.

Document US-A-5 955 243 discloses an illumination optical system comprising the feature summarized in the preamble of claim 1. The beam expander optical system of this known illumination optical system comprises three lens groups at least one of which is movable along the optical axis for varying the distances therebetween. The magnification of the beam expander optical system is changed by varying the distances between the lens groups thereof.

It is an object of the present invention to provide an illumination optical system designed such that the parallelism of the principle rays of the illumination light and thus the telecentricity at the object surface to be illuminated can easily be adjusted within a wide range. Furthermore, it is an object of the present invention to provide an exposure apparatus having the improved illumination optical system and a device fabrication method using the exposure apparatus having the improved illumination optical system.

According to a first aspect of the present invention, the first-mentioned object is achieved by the illumination optical system defined in claim 1.

Advantageous further developments of the invention are defined in the dependent claims.

A device fabrication method according to still another aspect of the present invention includes the steps of exposing an object using the above exposure apparatus, and developing the object exposed.

The devices fabricacted according to this fabricating method cover devices as intermediate and final products. Such devices include semiconductor chips like an LSI and VLSI, CCDs, LCDs, magnetic sensors, thin film magnetic heads, and the like.

Other objects and further features of the present invention will become readily apparent from the following description of the preferred embodiments with reference to the accompanying drawings.

FIG. 1 shows a simplified optical path of an illumination optical system according to one embodiment of the present invention.

FIG. 2 shows a lateral aberration in a meridional direction, a lateral aberration in a sagittal direction, a σ distortion, and a local σ at a first position in a condenser optical system in the illumination optical system shown in FIG. 1.

FIG. 3 shows a lateral aberration in a meridional direction, a lateral aberration in a sagittal direction, a σ distortion, and a local σ at a second position in a condenser optical system in the illumination optical system shown in FIG. 1.

FIG. 4 shows a simplified optical path of an exposure apparatus according to one embodiment of the present invention.

FIG. 5 shows a simplified optical path of an exposure apparatus according to another embodiment of the present invention.

FIG. 6 is a flowchart for explaining a method for fabricating devices (semiconductor chips such as ICs, LSIs, and the like, LCDs, CCDs, etc.).

FIG. 7 is a detailed flowchart of a wafer process in Step 4 of FIG. 6.

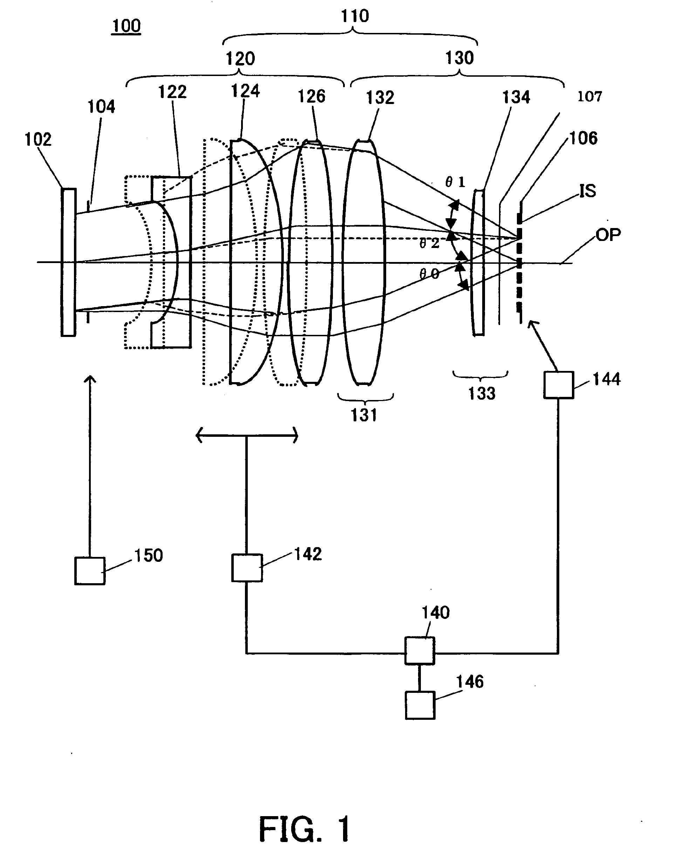

A description will be given of an illumination optical system 100 according to one embodiment of the present invention, with reference to FIG. 1. Here, FIG. 1 is shows a simplified optical path of the illumination optical system 100. The illumination optical system is part of an illumination apparatus or exposure apparatus, which further includes a controller 140, a moving mechanism 142, a detector 144, a memory 146, and an illumination condition varying section 150, in addition to the illumination optical system 100.

The illumination optical system 100 includes, as shown in FIG. 1, a secondary-light-source forming means 102, an aperture stop 104, a masking blade 106, and a condenser optical system 110, and illuminates an object surface IS using the light from a primary light source (not shown).

While the secondary-light-source forming means 102 is a fly-eye lens in the instant embodiment, it may be an optical rod, and another integrator or plural-light-source forming means. The aperture stop 104 is located as an incident pupil at an exit side of the secondary-light-source forming means 102. A position of the masking blade 106 is located at the object surface IS to be illuminated. Therefore, the secondary-light-source forming means 102 substantially has a Fourier transform relationship with the object surface IS. The object surface IS is located at the same surface as or a surface conjugate with a mask or reticle, which will be described later.

The condenser optical system 110 is located between the secondary-light-source forming means 102 and the masking blade 106, and serves to make the principal ray parallel to the optical axis OP (or perpendicular to the object surface IS) and to correct the telecentricity on the object surface IS.

The condenser optical system 110 includes, in order from an incident side along the optical axis, a first lens unit 120 and a second lens unit 130. Since the present invention is directed to a catoptric optical system that is broadly applicable to the EUV light, the first and second lens units 120 and 130 are broadly applied to the first and second optical systems. The first lens unit 120 serves to correct the telecentricity of the illumination light, and the second lens unit 130 serves to condense the light.

The first lens unit 120 includes, in order from the incident side along the optical axis, a concave lens 122, a convex lens 124, and a convex lens 126, forming a beam expander optical system. In order to vary the parallelism of the exit principal ray or the object-side telecentricity, the first lens unit 120 arranges the concave lens 122 at the incident side and the convex lenses 124 and 126 at the exit side, thereby forming the beam expander optical system that provides an exit ray diameter greater than an incident ray diameter when the first lens unit 120 receives parallel light.

The first lens unit (beam expander optical system) 120 is made movable as one member along the optical axis OP by the moving mechanism 142, which will be described later. Thus, a variation of the exit pupil position from the first lens unit 120 would change an exit pupil position of the entire condenser optical system 110 of this embodiment and the object-side telecentricity.

In order to restrain the focus variance and exit NA's fluctuations when the first lens unit 120 moves along the optical axis OP, the first lens unit 120 should meet the following Equation 1, where f1 is a focal distance of the first lens unit 120, and f2 is a focal distance of the second lens unit 130. Equation 1 is preferably Equation 2, and the instant embodiment sets a value of |f2 / f1| to 1.16:

$$|f2 / f1| \leq 2.5 \qquad\qquad\qquad (1)$$

$$|f2 / f1| \leq 1.2 \qquad\qquad\qquad (2)$$

A value of |f2 / f1| greater than 2.5 enlarges the moving amount in the optical axis OP direction and requires the second lens unit 130 to move, causing the moving mechanism 142 to be large, complex, and expensive. On the other hand, when it is equal to or smaller than 1.2, The telecentricity can be changed effectively and various aberrations can be properly reduced even when the first lens unit 120 is moved.

The following Equation 3 should be met, where P1 is an exit pupil distance of the first lens unit 120 that has the incident pupil position at the exit end of the secondary-light source means 102, in order to maintain a broad range of the telecentricity and to properly reduce various aberrations even when the first lens unit 120 is moved. Equation 3 is preferably Equation 4, and this embodiment provides $0.49 \leq |f2 / P1| \leq 0.65$:

$$|f2 / P1| \leq 1.0 \qquad\qquad (3)$$

$$0.4 \leq |f2 / P1| \leq 0.8 \qquad\qquad (4)$$

A value of $|f2 / P1|$ greater than 1.0 causes insufficient variances of the telecentricity even when the first lens unit 120 moves because of the weak refractive power of the second lens unit 130. A range between 0.4 and 0.8 practically prevents the variance of the telecentricity from being too insensitive and too sensitive when the first lens unit 120 is moved.

The object-side telecentricity of the condenser optical system 110 is made variable with the first lens unit 120 that meets $H2 / H1 = 1.5$ relative to the incident parallel light to the optical axis OP, where H1 is a height of the incident light in the first lens unit 120 from the optical axis, and H2 is a height of the exit light in the first lens unit 120 from the optical axis OP. In order to reduce various aberrations and maintain a wide variable range of the object-side telecentricity, the following Equation 5 should be met with respect to the height H1 of the incident light and the height H2 of the exit light:

$$1.3 \leq H2 / H1 \leq 1.7 \qquad\qquad (5)$$

$H2 / H1$ smaller than 1.3 provides the telecentricity with the improperly insensitive variability when the first lens unit 120 moves, since the incident height of the principal ray upon the second lens unit 130 is too low. $H2 / H1$ greater than 1.7 provides the telecentricity with the excessively sensitive variability when the first lens unit 120 moves, since the incident height of the principal ray upon the second lens unit 130 is too high.

In order to enlarge this light diameter difference for the larger variance of the telecentricity, the power of the concave lens 122 should be made greater. Therefore, the divergent angle of the exit light from the concave lens 122 should be large. For proper corrections of the various aberrations, the curvature of the incident surface of the concave lens 122 should be made stronger and the curvature of its exit surface should be made weaker. This embodiment uses an aspheric surface for the concave lens 122 in the first lens unit 120 so as to vary the object-side telecentricity, and make an aspheric exit side that has a curvature low enough to form an aspheric shape.

The second lens unit 130 includes a convex lens 132 and a convex lens 134 through a relatively wide space. The convex lens 132 is housed in a lens barrel 131, while the convex lens 134 is housed in a lens barrel 133.

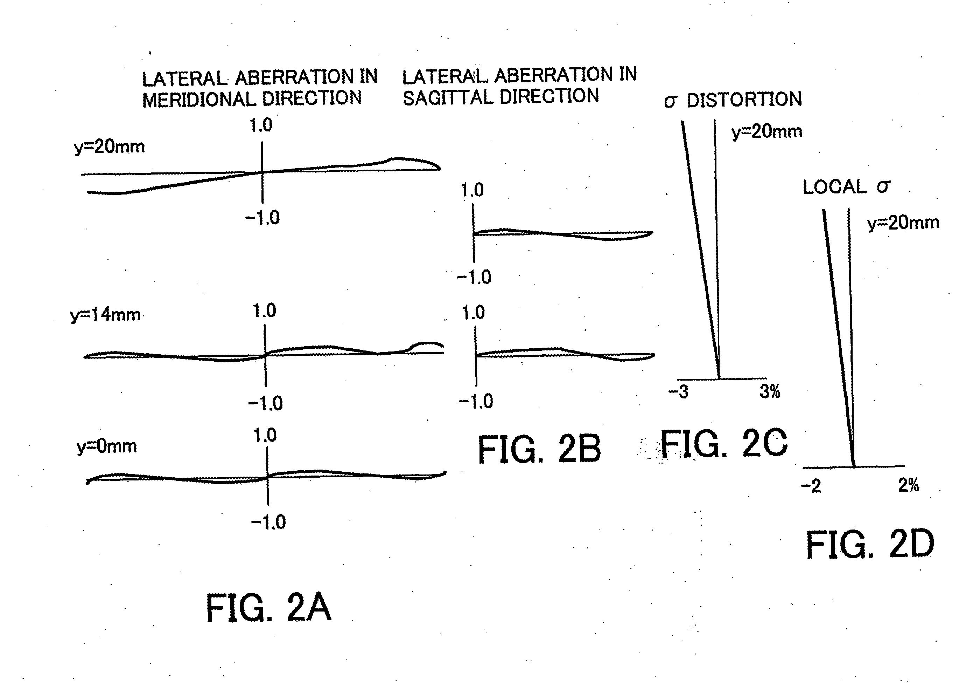

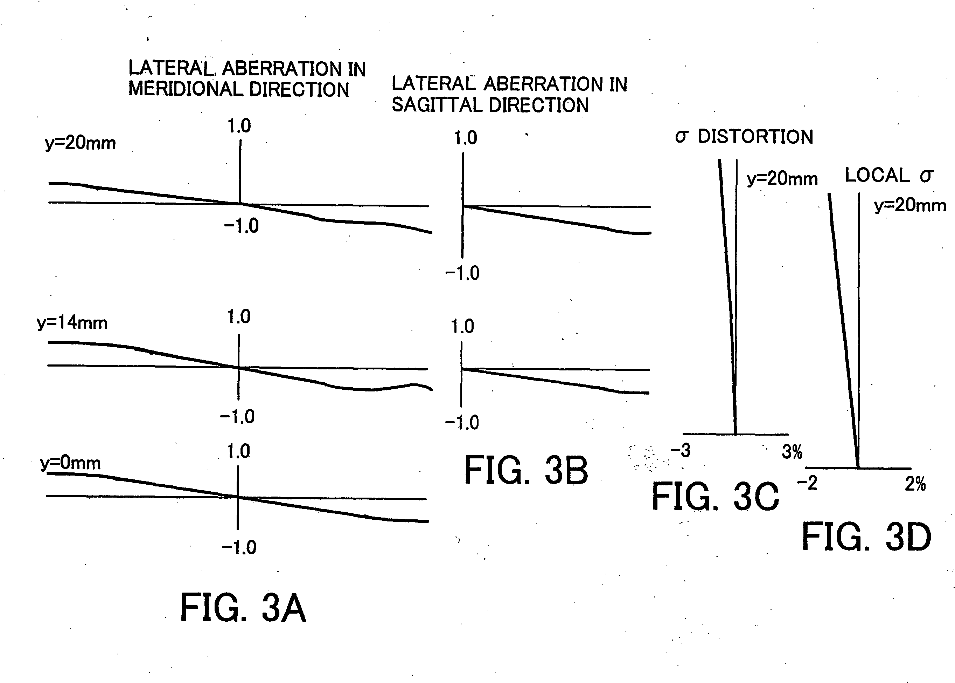

FIGs. 2 and 3 show aberrational diagrams at states where the first lens unit 120 and the second lens unit 130 are located closest to each other and separated farthest from each other. More specifically, FIG. 2A shows a lateral aberration in a meridional direction at a first position P1 of the condenser optical system 110. FIG. 2B shows a lateral aberration in a sagittal direction. FIG. 2C shows a $\sigma$ distortion. FIG. 2D shows a local $\sigma$. FIG. 3A shows a lateral aberration in a meridional direction at a second position $P_2$ of the condenser optical system 110. FIG. 3B shows a lateral aberration in a sagittal direction. FIG. 3C shows a $\sigma$ distortion. FIG. 3D shows a local $\sigma$. The aberrational diagram indicates a lateral aberration and $\sigma$ performance as major performance indexes. Here, the $\sigma$ performance is a performance index for evaluating properness on the illuminating light on the object surface IS, and is expressed by the $\sigma$ distortion and local $\sigma$. The $\sigma$ distortion and local $\sigma$ are expressed by the following equations, where $NA_0$ is a NA of axial light incident upon the object surface IS, $NA_1$ is a NA of an upper maximum ray of the light that condenses each image point on the object surface IS, and $NA_2$ is a numerical aperture of a lower maximum ray of the light that condenses each image point on the object surface IS:

$$\sigma \text{ distortion} = (NA_2 / NA_1 - 1) \times 100 \text{ [unit: \%]} \qquad (6)$$

$$\text{local } \sigma = \{(NA_1 + NA_2) / 2NA_0 - 1\} \times 100 \ [\text{unit: } \%] \ (7)$$

In the projection exposure apparatus, the deteriorated $\sigma$ distortion causes asymmetry of the exposed patterns between each image point on the exposed object, whereas the deteriorated local $\sigma$ causes scattering sizes of the exposed pattern among image points on the exposed object. In order to maintain the size errors of the exposed pattern on the object within the practically permissible level, the $\sigma$ distortion should be 3 % or smaller and local $\sigma$ should be 2 % or smaller.

The instant embodiment has such $\sigma$ performance that the $\sigma$ distortion has a maximum value of 2.5 % at the maximum image point at the position $P_1$, and the local $\sigma$ has a maximum value of 1.3 % at the maximum image point at the position $P_1$.

The condenser optical system of the instant embodiment meets the permissible level of the projection exposure apparatus that seeks for the fine processing of the circuit pattern.

Table 1 shows a specification of the condenser optical system 110, where f1 is the focal distance of the first lens unit 120, f2 is the focal distance of the second lens unit 130, f3 is the focal distance of the final lens 134 in the condenser optical system 110, and FA is a focal distance between both ends along the optical axis OP when the first lens unit 120 moves in condenser optical system 110 of this embodiment:

TABLE 1

| SPECIFICATION OF RE-IMAGING OPTICAL SYSTEM USED FOR EMBODIMENT OF THE PRESENT INVENTION | | | |
|---|---|---|---|
| $\lambda$=0.193$\mu$m, APERTURE-STOP DIAMETER =100mm, MAXIMUM IMAGE POINT=20mm | | | |

| | r | d | n | NOTES |
|---|---|---|---|---|
| 1: | $\infty$ | d1 : VARIABLE | 1 | APERTURE STOP |
| 2: | -110.88695 | 6. 3 | 1.560248 | 122 |
| * 3: | 1251.28760 | 41. 1 | 1 | |
| 4: | 4781.33767 | 46.5 | 1.560248 | 124 |
| 5: | -145.36814 | 13.3 | 1 | |
| 6: | 399.51554 | 37.0 | 1. 560248 | 126 |
| 7: | -399.51554 | d7 : VARIABLE | 1 | |
| *8: | 319.13142 | 37.5 | 1.560248 | 132 |
| 9: | -375.17503 | 101. 3 | 1 | 134 |
| 10: | 1818.23930 | 5.6 | 1.560248 | |
| 11: | $\infty$ | 42.2 | 1 | |
| EVALUATION: PLANE | $\infty$ | | | |

* SURFACE IS ASPHERIC SURFACE

| ASPHERIC COEFFICIENTS FOR THREE SURFACES | | ASPHERIC COEFFICIENTS FOR THREE SURFACES | |
|---|---|---|---|
| K= | -1.5 | K = | -0.226389 |
| A = | $+2.82370 \times 10^{-7}$ | A = | $-4.54215 \times 10^{-8}$ |
| B = | $-1.63956 \times 10^{-10}$ | B = | $+1.03037 \times 10^{-11}$ |
| C = | $+1.07552 \times 10^{-13}$ | C = | $-2.10279 \times 10^{-15}$ |
| D = | $-3.61647 \times 10^{-17}$ | D = | $+2.21972 \times 10^{-19}$ |
| E = | $+6.08217 \times 10^{-21}$ | E = | $-1.14313 \times 10^{-23}$ |
| F = | $-4.13907 \times 10^{-25}$ | F = | $+2.12935 \times 10^{-28}$ |

| SPECIFICATION AT EACH POSITION | | | FOCAL DISTANCES OF UNITS AND FINAL LENS | |
|---|---|---|---|---|
| POSITIONS | Z 1 | Z 2 | | |
| FA | 122. 9 | 125.4 | f1= | +254. 2 mm |
| d 1 | 46. 2 | 34.40 | f2= | +295. 7 mm |
| | | | f3= | +3245. 4 mm |

(continued)

| SPECIFICATION OF RE-IMAGING OPTICAL SYSTEM USED FOR EMBODIMENT OF THE PRESENT INVENTION | | | | |
|---|---|---|---|---|
| λ=0.193μm, APERTURE-STOP DIAMETER =100mm, MAXIMUM IMAGE POINT=20mm | | | | |
| | r | | d | n NOTES |
| d 7 | 7. 51 | 19.83 | HEIGHTS OF INCIDENT UGHT AND EXIT LIGHT FOR INCIDENT PARALLEL LIGHT | |
| P 1 | -603. 7 | -458.4 | H 1=5 | 0 mm |
| PA | +401. 4 | +570.4 | H 2= | 75. 2 mm |
| VALUES OF VARIOUS EQUATIONS RELATING TO CLAIMS f2/f1=1.16 $0.49 \leq |$ f2/P 1 $| \leq 0.65$ H 2/H 1=1. 50 $0.038 \leq |$ F A/f3 $| \leq 0.039$ | | | | |

In Table 1, P1 is an exit pupil distance at the first lens unit 120 when the aperture stop 104 is set as the incident pupil. PA is an exit pupil distance of the entire condenser optical system 110 when the aperture stop 104 is set as the incident pupil.

In Table 1 as a lens data table, r is a radius of curvature for each surface (unit: mm), d is a surface separation (unit: mm), and n is a refractive index of a medium relative to incident light (with a wavelength of 0.193 μm). An aspheric surface in Table 1 is given by the following Equation 8, where h is a height in a direction perpendicular to the optical axis at an arbitrary point on the aspheric surface, x is a distance along the optical axis direction, r is a radius of curvature at the apex, and K is a curvature coefficient, and A to K are aspheric coefficients: $x=h^2/r/[1+\{1-(1+K)(h/r)^2\}^{1/2}] +Ah^4+Bh^6+Ch^8+Dh^{10}+Eh^{12}+Fh^{14}$ (8)

According to the thus configured optical system, the instant embodiment according to the present invention uses an optical system that can properly reduce the image-point performance of the σ distortion and maintain a wider variable range of the object-side telecentricity using the smaller number of lenses.

The instant embodiment sets the focal distance FA of the condenser optical system 110 to 122.9 mm ≤ FA ≤ 125.4 mm, and the focal distance f3 of the convex lens 134 as the final lens to 3245.4 mm. Therefore, 0.038 ≤ FA /f3 ≤ 0.039 is met. The power of the convex lens 134 is smaller than that of the condenser optical system, and the decentering sensitivity of this lens is small. Therefore, even when the deteriorated convex lens 134 is exchanged with a new one or with a lens that has slightly different power, a variable range of the exit pupil position of the original condenser optical system can be shifted without aggravating other aberrations. The following Equation 9 should be met for such exchanges of parts. The instant embodiment enables the lens barrel 131 to be detachably connected to the lens barrel 132:

$$0.02 \leq |FA / f3| \leq 0.2 \qquad (13)$$

When a value of |FA / f3| is smaller than 0.02, the curvature of the convex lens 134 is too flat to be produced. When it exceeds 0.2, the decentering sensitivity when the convex lens 134 is exchanged becomes too strong, and the reproducibility of the optical performance deteriorates.

In general, the reticle and the object to be exposed have rectangular illumination areas in the exposure apparatus. Two pairs of shielding members for restricting the illumination area in orthogonal two directions within a section orthogonal to the optical axis OP are needed to restrict the illumination area of the object surface IS to a rectangular shape within a plane perpendicular to the optical axis OP. This embodiment assigns one pair to the masking blade 106 and the other pair to a scan blade 107, so as to use two pairs of shielding members as shielding means for determining an illumination area of the object surface IS. Then, the focus is moved slightly by moving the movable unit so that a light shielding position of the masking blade 106 is located near the focus position for the position $P_1$ when the first lens unit as a movable unit is located closest to the second lens unit as a fixed unit. Moreover, a light shielding position of the scan blade 107 is located near the focus position for the position $P_2$ when the first lens unit is located most distant from the second lens unit. Thereby, the condenser optical system 110 has the high irradiation energy efficiency of the irradiation light upon the object surface IS using the movements of the movable unit.

The masking blade 106, located optically conjugate with the object surface, is a stop that can automatically vary an aperture width or a length of the rectangular slit area in a longitudinal direction. The scan blade 107 is also a stop that can automatically vary an aperture width, and has the same structure as the masking blade. Use of these two variable blades can set a size of a transfer area in accordance with an exposure shot size.

The moving mechanism 142 is connected to the lens barrel that houses the first lens unit 120, and includes a uniaxial linear motor, etc. for moving the beam expander optical system as one member in the optical axis OP direction. The detector 144 detects the telecentricity on the object surface IS using a pinhole and an illuminance meter. The memory 146 stores a relationship between the telecentricity and the moving amount of the beam expander optical system 120. This relationship can be expressed as a table, a simulation result, an equation, etc. The controller 146 controls the moving amount of the beam expander optical system 120 by the moving mechanism 142 based on the detection result by the detector 144.

The illumination-condition varying section 150 serves as a selector and can vary the illumination conditions, such as an effective-light source shape (such as a circle, a dipole, and a quadrupole), σ, and an insertion/removal of a prism, for example, by providing plural types of stops on the turret and by rotating the turret. After the illumination-condition varying section 150 determines an illumination mode, the controller 146 determines a moving amount of the beam expander optical system 120.

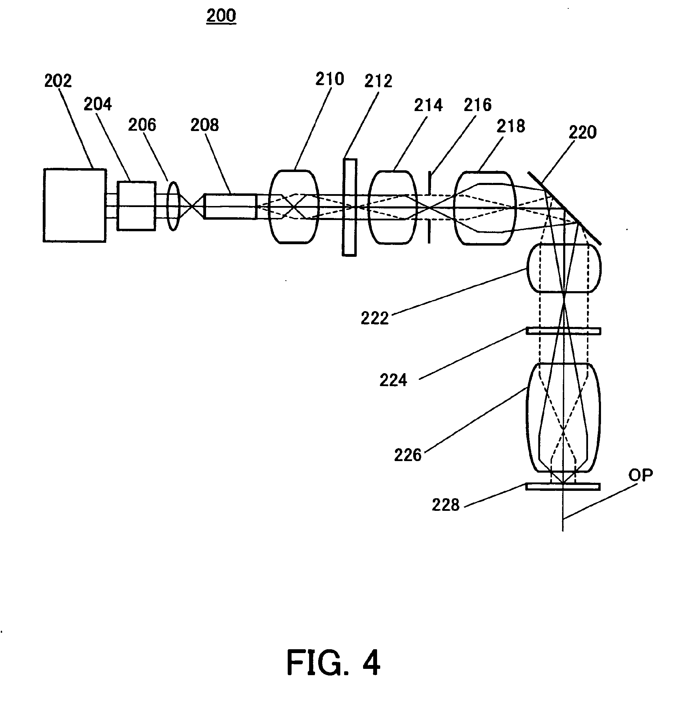

Referring now to FIG. 4, a description will be given of an exposure apparatus 200 according to an embodiment of the present invention. Here, FIG. 4 shows a simplified optical path of an exposure apparatus 200. The exposure apparatus 200 includes an illumination apparatus for illuminating a reticle (or mask) 224 which has a circuit pattern, and a projection optical system 226 for projecting the illuminated circuit pattern onto a plate 228.

The exposure apparatus 200 is a projection exposure apparatus that exposes onto the plate 228 a circuit pattern created on the mask 224, *e.g.*, in a step-and-repeat or a step-and-scan manner. Such an exposure apparatus is suitable for a sub-micron or quarter-micron lithography process. This embodiment exemplarily describes a step-and-scan exposure apparatus (which is also called "a scanner").

The illumination apparatus illuminates the mask 224 that has a circuit pattern to be transferred, and includes a light source unit and an illumination optical system according to the invention, such as the illumination optical system 100 shown in FIG. 1.

As an example, the light source unit uses laser for a light source 202 such as an ArF excimer laser with a wavelength of approximately 193 nm, a KrF excimer laser with a wavelength of approximately 248 nm and a $F_2$ laser with a wavelength of approximately 157 nm. However, the laser type is not limited. A beam shaping optical system 204 for shaping parallel light from the light source into a desired beam shape, and a relay optical system 206 are provided.

The illumination optical system is an optical system that illuminates the mask 224, and includes, a pillar glass 208 with a hexagonal section, a continuously σ variable optical system 210, a fly-eye lens 212, a masking blade irradiation optical system 214, a masking blade 216, a first optical system 218, a deflection mirror 220, and a second optical system 222.

The pillar glass 208 forms plural light sources from one light source using multiple reflections on inner surfaces of the glass. The light from the pillar glass 208 is incident upon the fly-eye lens 212 by the continuously σ variable optical system 210. The light from the fly-eye lens 212 is incident upon the masking blade 216 by the masking blade irradiation optical system 214. The masking blade irradiation optical system 214 is, for example, constituted by the condenser optical system 110 shown in FIG. 1. The light from the masking blade 216 irradiates the surface of the reticle 224 at the side of the circuit pattern by a mask imaging optical system.

The mask imaging optical system includes the first optical system 218, the mirror 220 that bends the optical axis OP by a right angle, and the second optical system 222.

The mask 224 forms a circuit pattern (or an image) to be transferred, and is supported and driven by a reticle stage (not shown). Diffracted light emitted from the mask 224 passes through the projection optical system 226 and is then projected onto the plate 228. The plate 228, such as a wafer and a LCD, is an exemplary object to be exposed. A photoresist is applied onto the plate 228. The reticle 224 and the plate 228 are located in an optically conjugate relationship. The scanner scans the reticle 224 and the plate 228, and transfers the pattern on the mask 224 onto the plate 228. In case of a stepper, the mask 224 and the plate 228 remain still during exposure.

The projection optical system 226 may use an optical system comprising solely of a plurality of lens elements, an optical system including a plurality of lens elements and at least one mirror (a catadioptric optical system), an optical system including a plurality of lens elements and at least one diffractive optical element such as a kinoform, a full mirror type optical system, and so on. Any necessary correction of the chromatic aberration may be accomplished by using a plurality of lens units made from glass materials having different dispersion values (Abbe values) or arranging a diffractive optical element such that it disperses light in a direction opposite to that of the lens unit.

In exposure, the light is emitted from the light source unit 202, *e.g.*, Koehler-illuminates the mask 224 via the illumination optical system. The light that passes through the mask 224 and transfers the mask pattern is imaged onto the plate 228 by the projection optical system 226. In that case, the masking blade irradiation optical system 214 constituted by the condenser optical system 110 of the illumination optical system 100 shown in FIG. 1 maintains the intended telecentricity and provides high-quality exposure to the plate 228 at a high NA. In addition, the instant structure is simpler than that according to document JP-A-2002-184676, because only the first lens unit 120 moves in FIG. 1, and the second lens unit 130 does not have to move. Since the second lens unit 130 prevents fluctuations of a spot diameter associated with movements of the condenser optical system, and thus maintains the irradiation efficiency, providing devices with high throughput and economic efficiency, such as a semiconductor device, an LCD device, an image-pickup device (such as a CCD), and a thin-film magnetic head.

The projection exposure apparatus 200 shown in FIG. 4 uses a mask imaging optical system (218 to 222) having twice imaging magnification, and has the imaging magnification of 1 / 4 between the reticle 224 and the plate 228, and the maximum σ value of 0.95, which indicates a ratio between the NA of the projection optical system 226 to the NA of the illumination optical system. When the condenser optical system 110 of the instant embodiment is applied to the projection exposure apparatus, the imaging NA is 0.84 at the plate 228 side since the exit-side NA is 0.40. By applying such configured condenser optical system 110 to the masking blade irradiation optical system 214, the projection exposure apparatus 200 can properly correct the offset telecentricity at the wafer side caused by the manufacturing errors of each optical element and assembly errors of the optical unit, using the smaller number of lenses and a simpler structure.

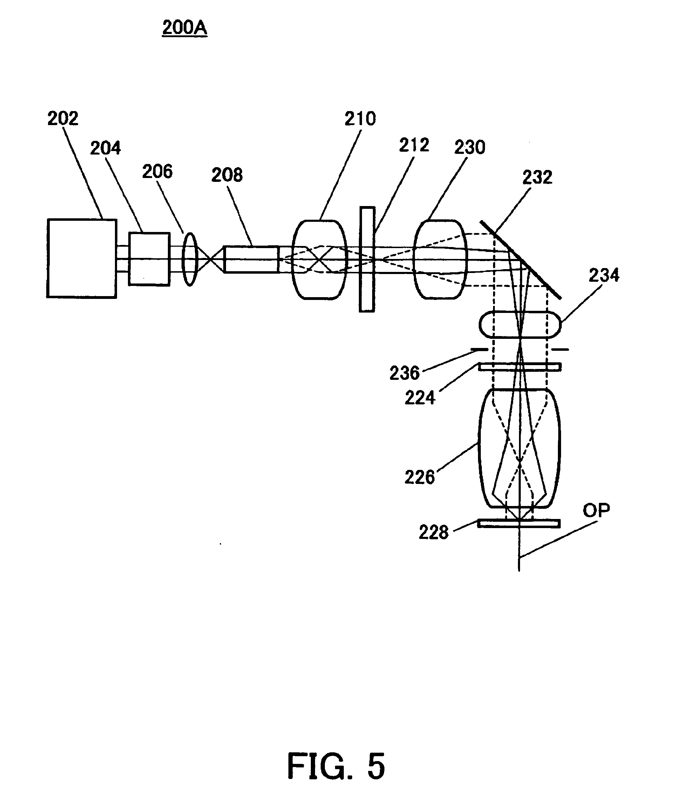

The condenser optical system 110 of the present invention is also applicable, for example, to a projection exposure apparatus 200A of a step-and-scan manner shown in FIG. 5. Here, FIG. 5 shows a simplified optical path of the exposure apparatus 200A. Those elements in FIG. 5, which are corresponding elements in FIG. 4, are designated by the same reference numeral, and a detailed description thereof will be omitted. The condenser optical system 110 shown in FIG. 1 is applied to the reticle irradiation optical system in FIG. 5.

The reticle irradiation optical system 230 to 234 irradiates the light from the fly-eye lens 212 onto the circuit pattern surface of the reticle 224. The projection optical system 226 projects the light from the circuit pattern surface of the reticle onto the plate 228 at a reduced size, onto which plate 228 a photosensitive material is applied. Here, the reticle irradiation optical system includes a first optical system 230, a deflection mirror 232 for bending the optical axis OP direction by the right angle, and a second optical system 234. The condenser optical system 110 is applied to this reticle irradiation optical system. In other words, the first optical system 230 is assigned to one that includes the concave lens 122 to the convex lens 132, and the second optical system 234 is assigned to the concave lens 134. The masking blade 236 for eliminating the irradiation light outside the effective irradiation area is arranged at the exit side of the condenser optical system 110.

The projection exposure apparatus 200A shown in FIG. 5 has the imaging magnification of 1 / 4 between the reticle 224 and the plate 228, and the maximum σ value of 0.95, which indicates a ratio between the NA of the projection optical system 226 to the NA of the illumination optical system. When the aperture stop diameter of the condenser optical system 110 is 50 mm and the condenser optical system 110 is applied to the reticle illumination optical system 230 to 234 shown in FIG. 5, the projection exposure apparatus has the imaging NA of 0.84 at the plate 228 side since the exit-side NA is 0.20. By applying such configured condenser optical system 110 as the reticle irradiation optical system to the illumination apparatus, the projection exposure apparatus 200 can properly correct the offset telecentricity at the wafer side caused by the manufacturing errors of each optical unit, using the smaller number of lenses and a simpler structure.

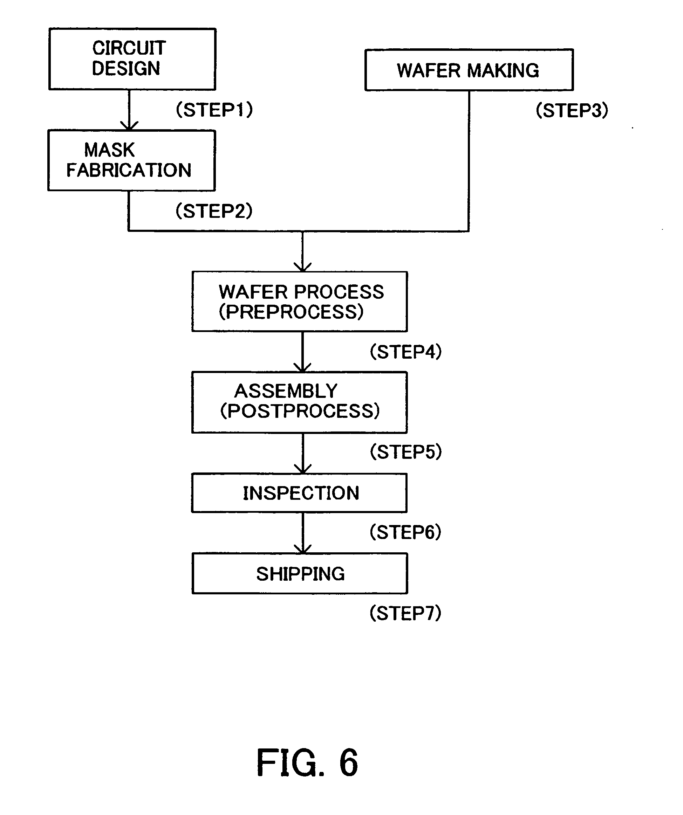

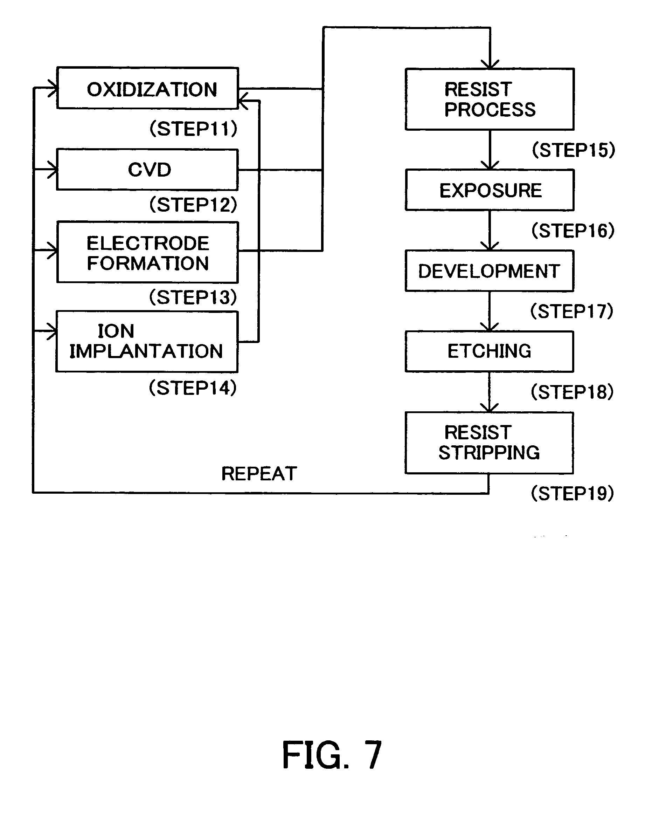

Referring now to FIGs. 6 and 7, a description will be given of a device fabrication method using the above mentioned exposure apparatuses 200 and 200A. FIG. 6 is a flowchart for explaining how to fabricate devices (i.e., semiconductor chips such as IC and LSI, LCDs, CCDs, and the like). Here, a description will be given of the fabrication of a semiconductor chip as an example. Step 1 (circuit design) designs a semiconductor device circuit. Step 2 (mask fabrication) forms a mask having a designed circuit pattern. Step 3 (wafer making) manufactures a wafer using materials such as silicon. Step 4 (wafer process), which is also referred to as a pretreatment, forms the actual circuitry on the wafer through lithography using the mask and wafer. Step 5 (assembly), which is also referred to as a post-treatment, forms into a semiconductor chip the wafer formed in Step 4 and includes an assembly step (*e.g.*, dicing, bonding), a packaging step (chip sealing), and the like. Step 6 (inspection) performs various tests on the semiconductor device made in Step 5, such as a validity test and a durability test. Through these steps, a semiconductor device is finished and shipped (Step 7).

FIG. 7 is a detailed flowchart of the wafer process in Step 4. Step 11 (oxidation) oxidizes the wafer' s surface. Step 12 (CVD) forms an insulating layer on the wafer's surface. Step 13 (electrode formation) forms electrodes on the wafer by vapor disposition and the like. Step 14 (ion implantation) implants ions into the wafer. Step 15 (resist process) applies a photosensitive material onto the wafer. Step 16 (exposure) uses the exposure apparatuses 200 and 200A to expose a circuit pattern from the mask onto the wafer. Step 17 (development) develops the exposed wafer. Step 18 (etching) etches parts other than a developed resist image. Step 19 (resist stripping) removes unused resist after etching. These steps are repeated to form multi-layer circuit patterns on the wafer. The fabrication method of the instant embodiment can obtain the desired telecentricity using the condenser optical system 110, and can fabricate higher-quality devices (having a desired critical dimension). Thus, the device fabrication method using the exposure apparatus constitutes one aspect of the present invention.

Furthermore, the present invention is not limited to these preferred embodiments and various variations and modifications may be made without departing from the scope of the present invention as defined by the claims.

**Claims**

1. An illumination optical system for illuminating an object surface (IS) using light from a light source (102), said illumination optical system (100) including a condenser optical system (110) for directing the light from the light source (102) to the object surface (IS),
   wherein said condenser optical system (110) includes, in order from an incident side, first and second optical systems (120, 130), and
   wherein said first optical system forms a beam expander optical system (120) for varying a diameter of incident light and includes a concave lens (122) at its incident side,
   **characterized in that**
   said beam expander optical system (120) is adapted to be moved as one element along an optical axis (OP).

2. The illumination optical system according to claim 1,
   wherein the condition $|f2 / f1| \leq 2.5$ is met, where f1 is the focal distance of said beam expander optical system (120), and f2 is the focal distance of the second optical systems (130).

3. The illumination optical system according to claim 1 or 2,
   wherein the condition $|f2 / P1| \leq 1.0$ is met, where P1 is an exit pupil distance of said beam expander optical system (120) and f2 is the focal distance of said second optical systems (130).

4. The illumination optical system according to one of claims 1 to 3, wherein the condition $1.3 \leq H2 / H1 \leq 1.7$ is met, where when light parallel to the optical axis (OP) and having a maximum height of H1 from the optical axis (OP) is incident upon said beam expander optical system (120), the light exits said beam expander optical system (120) with a maximum height of H2.

5. The illumination optical system according to one of claims 1 to 4, wherein said concave lens (122) has an aspheric surface.

6. The illumination optical system according to one of claims 1 to 5, wherein the conditions:

$$0.97 \leq \sin\theta_2 / \sin\theta_1 \leq 1.03;$$

and

$$0.98 \leq (\sin\theta_1 + \sin\theta_2) / 2\sin\theta_0 \leq 1.02$$

are met, where $\theta_0$ is an absolute value of an angle between an upper maximum ray of axial light incident upon the object surface (IS) and the optical axis (OP), $\theta_1$ is an angle between a principal ray and the upper maximum ray of the light that condenses at a maximum image point on the object surface (IS),
   and $\theta_2$ is an angle between the principal ray and a lower maximum ray.

7. The illumination optical system according to claim 1,
   wherein said second optical systems (130) includes:

   a first optical element (134) located at an outermost side of said condenser optical system (110);
   a first barrel (133) for holding said first optical element (134);
   a second optical element (132) different from said first optical element (134); and
   a second barrel (131) for holding said second optical element (132), said second barrel (131) being detachably connected to said first barrel (133),
   wherein the condition $0.02 \leq |FA / f3| \leq 0.2$ is met, where FA is a focal distance of said condenser optical system (110), and f3 is the focal distance of said first optical element (134).

8. The illumination optical system according to one of claims 1 to 7, further comprising a shield for defining an illuminated area having a rectangular shape on the object surface (IS),
wherein said shield includes two pairs (106, 107) of shielding members each of which defines a pair of parallel sides of the rectangular shape,
wherein one (106) of the two pairs of shielding parts is located near the focus position of said condenser optical system (110), when said beam expander optical system (120) is located at one end of its movable range along the optical axis (OP),
and wherein the other (107) of the two pairs of shielding parts is located near the focus position of said condenser optical system (110), when said beam expander optical system (120) is located at the other end of its movable range along the optical axis (OP).

9. The illumination optical system according to one of claims 1 to 8, further comprising an optical integrator having an exit end that substantially has a Fourier transform relationship with the object surface (IS).

10. The illumination optical system according to one of claims 1 to 9, wherein an absolute value of a $\sigma$ distortion that is defined as $(NA_2 / NA_1 - 1) \times 100$ is smaller than 3, where $NA_1$ is a numerical aperture of an upper maximum ray of the light that condenses each image point on the object surface (IS), and $NA_2$ is a numerical aperture of a lower maximum ray of the light that condenses each image point on the object surface (IS).

11. The illumination optical system according to one of claims 1 to 10, wherein an absolute value of a local $\sigma$ that is defined as $\{(NA_1 + NA_2) / 2NA_0 - 1\} \times 100$ is smaller than 2, where $NA_0$ is a numerical aperture of axial light incident upon the object surface (IS), $NA_1$ is a numerical aperture of an upper maximum ray of the light that condenses each image point on the object surface (IS), and $NA_2$ is a numerical aperture of a lower maximum ray of the light that condenses each image point on the object surface (IS).

12. An exposure apparatus comprising:

the illumination optical system according to one of claims 1 to 11, wherein a reticle (224) is located on or conjugate to the object surface (IS), and
a projection optical system (226) for projecting a pattern of the reticle (224) onto an object (228) to be exposed.

13. The exposure apparatus according to claim 12, wherein said projection optical system (226) has a numerical aperture of 0.8 or greater.

14. The exposure apparatus according to claim 12 or 13, further comprising:

a moving mechanism (142) for moving said beam expander optical system (120) as one element along the optical axis (OP);
a detector (144) for detecting a telecentricity on the reticle (224);
a memory (146) for storing a relationship between the telecentricity and a moving amount of said beam expander optical system (120); and
a controller (140) for controlling the moving amount of said beam expander optical system (120) by said moving mechanism (142) based on a detection result by said detector (144).

15. The exposure apparatus according to one of claims 12 to 14, further comprising a selector (150) for selecting one of plural types of illumination conditions,
wherein said detector (144) detects the telecentricity on the reticle (224) after the selector (150) selects.

16. A device fabrication method comprising the steps of:

exposing an object (228) using an exposure apparatus according to one of claims 12 to 15; and
developing the object (228) exposed.

**Patentansprüche**

1. Optisches Beleuchtungssystem zum Beleuchten einer Objektfläche (IS) unter Verwendung von Licht von einer Lichtquelle (102), wobei das optische Beleuchtungssystem (100) ein optisches Kondensorsystem (110) zum Hinlenken des Lichts von der Lichtquelle (102) auf die Objektfläche (IS) beinhaltet,

wobei das optische Kondensorsystem (110), in Reihenfolge von der Einfallseite her, erste und zweite optische Systeme (120, 130) beinhaltet, und

wobei das erste optische System ein optisches Strahlaufweitungssystem (120) zum Variieren eines Durchmessers von einfallendem Licht bildet und eine Konkavlinse (122) an seiner Einfallsseite beinhaltet,

**dadurch gekennzeichnet, dass**

das optische Strahlaufweitungssystem (120) angepasst ist, als ein Element entlang einer optischen Achse (OP) bewegt zu werden.

2. Optisches Beleuchtungssystem nach Anspruch 1, wobei die Bedingung |f2/f1| ≤ 2,5 erfüllt ist, wobei f1 die Brennweite des optischen Strahlaufweitungssystems (120) ist, und f2 die Brennweite des zweiten optischen Systems (130) ist.

3. Optisches Beleuchtungssystem nach Anspruch 1 oder 2,
wobei die Bedingung |f2/P1| ≤ 1,0 erfüllt ist, wobei P1 ein Austrittspupillenabstand des optischen Strahlaufweitungssystems (120) ist und f2 die Brennweite des zweiten optischen Systems (130) ist.

4. Optisches Beleuchtungssystem nach einem der Ansprüche 1 bis 3, wobei die Bedingung 1.3 ≤ H2/H1 ≤ 1.7 erfüllt ist, wobei Licht aus dem optischen Strahlaufweitungssystem (120) mit einer maximalen Höhe H2 austritt, wenn das Licht parallel zu der optischen Achse (OP) und mit einer maximalen Höhe H1 von der optischen Achse (OP) in das optische Strahlaufweitungssystem (120) einfällt.

5. Optisches Beleuchtungssystem nach einem der Ansprüche 1 bis 4, wobei die Konkavlinse (122) eine asphärische Fläche hat.

6. Optisches Beleuchtungssystem nach einem der Ansprüche 1 bis 5, wobei die Bedingungen:

$$0,97 \leq \sin \Theta_2 \; / \; \sin \Theta_1 \leq 1,03;$$

und

$$0,98 \leq (\sin \Theta_1 + \sin \Theta_2) \; / \; 2*\sin \Theta_0 \leq 1,02$$

erfüllt sind, wobei $\Theta_0$ ein Absolutwert eines Winkels zwischen einem oberen Maximalstrahl von auf die Objektfläche (IS) einfallendem axialem Licht und der optischen Achse (OP) ist, $\Theta_1$ ein Winkel zwischen einem Hauptstrahl und dem oberen Maximalstrahl des Lichts ist, das an einem maximalen Bildpunkt auf der Objektfläche (IS) einfällt; und $\Theta_2$ ein Winkel zwischen dem Hauptstrahl und einem unteren Maximalstrahl ist.

7. Optisches Beleuchtungssystem nach Anspruch 1, wobei das zweite optische System (130) beinhaltet:

ein erstes optisches Element (134), das an einer äußersten Seite des optischen Kondensorsystems (110) angeordnet ist;
einen ersten Zylinder (133) zum Halten des ersten optischen Elements (134);
ein zweites optisches Element (132), das von dem ersten optischen Element (134) verschieden ist; und
einen zweiten Zylinder (131) zum Halten des zweiten optischen Elements (132), wobei der zweite Zylinder (131) abtrennbar mit dem ersten Zylinder (133) verbunden ist,
wobei die Bedingung 0,02 ≤ |FA / f3| ≤ 0,2 erfüllt ist, wobei FA eine Brennweite des optischen Kondensorsystems (110) ist und f3 die Brennweite des ersten optischen Elements (134) ist.

8. Optisches Beleuchtungssystem nach einem der Ansprüche 1 bis 7, ferner mit einer Abschirmung zum Definieren einer beleuchteten Fläche mit einer rechteckigen Form auf der Objektfläche (IS),
wobei die Abschirmung zwei Paare (106, 107) von Abschirmbauteilen beinhaltet, deren jedes ein Paar von parallelen Seiten der rechteckigen Form definiert,
wobei eines (106) der zwei Paare von Abschirmteilen nahe der Brennpunktposition des optischen Kondensorsystems (110) angeordnet ist, wenn das optische Strahlaufweitungssystem (120) an einem Ende des Bereichs, den es sich entlang der optischen Achse (OP) bewegen kann, angeordnet ist, und

wobei das andere (107) der zwei Paare von Abschirmteilen nahe der Brennpunktposition des optischen Kondensorsystems (110) angeordnet ist, wenn das optische Strahlaufweitungssystem (120) an dem anderen Ende des Bereichs, den es sich entlang der optischen Achse (OP) bewegen kann, angeordnet ist.

9. Optisches Beleuchtungssystem nach einem der Ansprüche 1 bis 8, ferner mit einem optischen Integrator mit einem Austrittsende, das im Wesentlichen eine Fouriertransformationsbeziehung zu der Objektfläche (IS) hat.

10. Optisches Beleuchtungssystem nach einem der Ansprüche 1 bis 9, wobei ein Absolutwert einer σ Verzerrung, die als $(NA_2 / NA_1 -1) * 100$ definiert ist, kleiner als 3 ist, wobei $NA_1$ eine numerische Apertur eines oberen Maximalstrahls des Lichts ist, das an jedem Bildpunkt auf der Objektfläche (IS) einfällt, und $NA_2$ eine numerische Apertur eines unteren Maximalstrahls des Lichts ist, das an jedem Bildpunkt auf der Objektfläche (IS) einfällt.

11. Optisches Beleuchtungssystem nach einem der Ansprüche 1 bis 10, wobei ein Absolutwert eines lokalen σ, das als $\{(NA_1 + NA_2) / 2NA_0 -1\} * 100$ definiert ist, kleiner als 2 ist, wobei $NA_0$ eine numerische Apertur von auf die Objektfläche (IS) fallendem axialem Licht ist, $NA_1$ eine numerische Apertur eines oberen Maximalstrahls des Lichts ist, das an jedem Bildpunkt auf der Objektfläche (IS) einfällt, und $NA_2$ eine numerische Apertur eines unteren Maximalstrahls des Lichts ist, das an jedem Bildpunkt auf der Objektfläche (IS) einfällt.

12. Belichtungsvorrichtung mit:

dem optischen Beleuchtungssystem nach einem der Ansprüche 1 bis 11, wobei eine Maske (224) auf oder konjugiert zu der Objektfläche (IS) angeordnet ist, und

einem optischen Projektionssystem (226) zum Projizieren eines Musters der Maske (224) auf ein zu belichtendes Objekt (228).

13. Belichtungsvorrichtung nach Anspruch 12, wobei das optische Projektionssystem (226) eine numerische Apertur von 0,8 oder größer hat.

14. Belichtungsvorrichtung nach Anspruch 12 oder 13, ferner mit:

einem Bewegungsmechanismus (142) zum Bewegen des optischen Strahlaufweitungssystems (120) als einem Element entlang der optischen Achse (OP);

einem Detektor (144) zum Erfassen einer Telezentrizität auf der Maske (224);

einer Speichereinheit (146) zum Speichern einer Beziehung zwischen der Telezentrizität und einer Bewegungsmenge des optischen Strahlaufweitungssystems (120); und

einer Steuereinheit (140) zum Steuern der Bewegungsmenge des optischen Strahlaufweitungssystems (120) durch den Bewegungsmechanismus (142) auf der Grundlage eines Erfassungsergebnisses durch den Detektor (144).

15. Belichtungsvorrichtung nach einem der Ansprüche 12 bis 14, ferner mit einer Auswähleinheit (150) zum Auswählen eines von mehreren Typen von Beleuchtungszuständen,

wobei der Detektor (144) die Telezentrizität auf der Maske (224) erfasst, nachdem die Auswähleinheit (150) auswählt.

16. Geräteherstellungsverfahren mit den Schritten:

Belichten eines Objekts (228) unter Verwendung einer Belichtungsvorrichtung nach einem der Ansprüche 12 bis 15; und

Entwickeln des belichteten Objekts (228).

**Revendications**

1. Système optique d'illumination destiné à illuminer une surface (IS) d'un objet en utilisant une lumière provenant d'une source de lumière (102), ledit système optique (100) d'illumination comprenant un système optique condenseur (110) destiné à diriger la lumière provenant de la source de lumière (102) sur la surface (IS) de l'objet,

dans lequel ledit système optique condenseur (110) comprend, dans l'ordre depuis un côté d'incidence, des premier et second systèmes optiques (120, 130), et

dans lequel ledit premier système optique forme un système optique (120) d'expansion de faisceau destiné à faire varier le diamètre de la lumière incidente et comprend une lentille concave (122) sur son côté d'incidence, **caractérisé en ce que**
ledit système optique d'expansion de faisceau (120) est conçu pour être déplacé en un élément le long d'un axe optique (OP).

2. Système optique d'illumination selon la revendication 1, dans lequel la condition |f2 / f1| ≤ 2,5 est satisfaite, où f1 est la distance focale du système optique d'expansion de faisceau (120), et f2 est la distance focale des seconds systèmes optiques (130).

3. Système optique d'illumination selon la revendication 1 ou 2,
dans lequel la condition |f2 / P1| ≤ 1,0 est satisfaite, où P1 est la distance de la pupille de sortie dudit système optique (120) d'expansion de faisceau et f2 est la distance focale desdits seconds systèmes optiques (130).

4. Système optique d'illumination selon l'une des revendications 1 à 3, dans lequel la condition 1,3 ≤ H2 /H1 ≤ 1,7 est satisfaite, où, lorsque de la lumière parallèle à l'axe optique (OP) et ayant une hauteur maximale de H1 par rapport à l'axe optique (OP) est incidente sur ledit système optique (120) d'expansion de faisceau, la lumière émerge dudit système optique (120) d'expansion de faisceau avec une hauteur maximale de H2.

5. Système optique d'illumination selon l'une des revendications 1 à 4, dans lequel ladite lentille concave (122) a une surface asphérique.

6. Système optique d'illumination selon l'une des revendications 1 à 5, dans lequel les conditions

$$0,97 \leq \mathrm{Sin}\theta_2 / \mathrm{Sin}\theta_1 \leq 1,03 ;$$

et

$$0,98 \leq (\mathrm{Sin}\theta_1 / \mathrm{Sin}\theta_2) / 2\mathrm{Sin}\theta_0 \leq 1,02$$

sont satisfaites, où $\theta_0$ est la valeur absolue d'un angle formé entre le rayon maximal supérieur de la lumière axiale tombant sur la surface (IS) de l'objet et l'axe optique (OP), $\theta_1$ est l'angle formé entre un rayon principal et le rayon maximal supérieur de la lumière qui se condensent en un point image maximal sur la surface (IS) de l'objet, et $\theta_2$ est l'angle formé entre le rayon principal et le rayon maximal inférieur.

7. Système optique d'illumination selon la revendication 1, dans lequel lesdits seconds systèmes optiques (130) comprennent :

un premier élément optique (134) placé sur un côté situé le plus à l'extérieur dudit système optique condenseur (110) ;
un premier tambour (133) destiné à maintenir ledit premier élément optique (134) ;
un second élément optique (132) différent dudit premier élément optique (134) ; et
un second tambour (131) destiné à maintenir ledit second élément optique (132), ledit second tambour (131) étant relié de façon amovible audit premier tambour (133),
dans lequel la condition 0,02 ≤ | FA / f3| ≤ 0,2 est satisfaite, où FA est la distance focale dudit système optique condenseur (110), et f3 est la distance focale dudit premier élément optique (134).

8. Système optique d'illumination selon l'une des revendications 1 à 7, comportant en outre un écran destiné à définir une zone illuminée ayant une forme rectangulaire sur la surface (IS) de l'objet,
dans lequel ledit écran comprend deux paires (106, 107) d'éléments formant écran qui définissent chacun une paire de côtés parallèles de la forme rectangulaire,
dans lequel l'une (106) des deux paires de parties formant écran est placée à proximité de la position focale dudit système optique condenseur (110), lorsque ledit système optique (120) d'expansion de faisceau est placé à une extrémité de sa plage de mouvement possible le long de l'axe optique (OP),
et dans lequel l'autre (107) des deux paires de partie formant écran est placé à proximité de la position focale dudit système optique condenseur (110), lorsque ledit système optique (120) d'expansion de faisceau est placé à l'autre extrémité de sa plage de déplacement possible le long de l'axe optique (OP).

9. Système optique d'illumination selon l'une des revendications 1 à 8, comportant en outre un intégrateur optique ayant une extrémité de sortie qui est sensiblement dans une relation de transformation de Fourier avec la surface d'objet (IS).

10. Système optique d'illumination selon l'une des revendications 1 à 9, dans lequel la valeur absolue d'une distorsion o qui est définie comme $(NA_2 / NA_1 - 1) \times 100$ est inférieure à 3, où $NA_1$ est l'ouverture numérique du rayon maximal supérieur de la lumière qui condense chaque point d'image sur la surface d'objet (IS), et $NA_2$ est l'ouverture numérique du rayon maximal inférieur de la lumière qui condense chaque point d'image sur la surface d'objet (IS).

11. Système optique d'illumination selon l'une des revendications 1 à 10, dans lequel la valeur absolue d'un o local qui est défini comme $\{(NA_1 + NA_2) / 2NA_0 - 1\} \times 100$ est inférieure à 2, où $NA_0$ est l'ouverture numérique d'une lumière axiale tombant sur la surface d'objet (IS), $NA_1$ est l'ouverture numérique d'un rayon maximal supérieur de la lumière qui condense chaque point d'image sur la surface d'objet (IS), et $NA_2$ est l'ouverture numérique d'un rayon maximal inférieur de la lumière qui condense chaque point d'image sur la surface d'objet (IS).

12. Appareil d'exposition comportant :

le système optique d'illumination selon l'une des revendications 1 à 11, dans lequel un réticule (224) est placé sur ou est conjugué avec la surface d'objet (IS), et
un système optique de projection (226) destiné à projeter un motif du réticule (224) sur un objet (228) devant être exposé.

13. Appareil d'exposition selon la revendication 12,
dans lequel ledit système optique de projection (226) a une ouverture numérique de 0,8 ou plus.

14. Appareil d'exposition selon la revendication 12 ou 13, comportant en outre :

un mécanisme de déplacement (142) destiné à déplacer ledit système optique (120) d'expansion de faisceau sous la forme d'un élément le long de l'axe optique (OP) ;
un détecteur (144) destiné à détecter une télécentricité sur le réticule (224) ;
une mémoire (146) destinée à stocker une relation entre la télécentricité et une grandeur de déplacement dudit système optique (120) d'expansion de faisceau ; et
une unité de commande (140) destinée à commander la grandeur de déplacement dudit système optique (120) d'expansion de faisceau par ledit mécanisme de déplacement (142) sur la base d'un résultat de détection par ledit détecteur (144).

15. Appareil d'exposition selon l'une des revendications 12 à 14, comportant en outre un sélecteur (150) destiné à sélectionner l'un de plusieurs types de conditions d'illumination,
dans lequel ledit détecteur (144) détecte la télécentricité sur le réticule (224) après une sélection par le sélecteur (150).

16. Procédé de fabrication de dispositifs comprenant les étapes qui consistent :

à exposer un objet (228) en utilisant un appareil d'exposition selon l'une des revendications 12 à 15 ; et
à développer l'objet (228) exposé.

FIG. 1

LATERAL ABERRATION IN
MERIDIONAL DIRECTION

LATERAL ABERRATION IN
SAGITTAL DIRECTION

σ DISTORTION

FIG. 2A

FIG. 2B

FIG. 2C

FIG. 2D

EP 1 522 893 B1

LATERAL ABERRATION IN
MERIDIONAL DIRECTION

LATERAL ABERRATION IN
SAGITTAL DIRECTION

y=20mm

1.0

-1.0

1.0

-1.0

$\sigma$ DISTORTION

y=20mm

LOCAL $\sigma$

y=20mm

y=14mm

1.0

-1.0

1.0

-1.0

FIG. 3B

-3        3%

FIG. 3C

y=0mm

1.0

-1.0

-2        2%

FIG. 3D

FIG. 3A

EP 1 522 893 B1

200

FIG. 4

## 200A

FIG. 5

CIRCUIT
DESIGN

(STEP1)

MASK
FABRICATION

(STEP2)

WAFER MAKING

(STEP3)

WAFER PROCESS
(PREPROCESS)

(STEP4)

ASSEMBLY
(POSTPROCESS)

(STEP5)

INSPECTION

(STEP6)

SHIPPING

(STEP7)

# FIG. 6

OXIDIZATION

(STEP11)

CVD

(STEP12)

ELECTRODE
FORMATION

(STEP13)

ION
IMPLANTATION

(STEP14)

REPEAT

RESIST
PROCESS

(STEP15)

EXPOSURE

(STEP16)

DEVELOPMENT

(STEP17)

ETCHING

(STEP18)

RESIST
STRIPPING

(STEP19)

# FIG. 7

**EP 1 522 893 B1**

**REFERENCES CITED IN THE DESCRIPTION**

**Patent documents cited in the description**

- JP 2001155993 A
- JP 2002184676 A
- US 20010033433 A1
- US 5955243 A